# EUROPÄISCHE PATENTANMELDUNG

(11) **EP 2 469 596 A2**
(43) Veröffentlichungstag der Anmeldung: **27.06.2012**
(21) Anmeldenummer: 11192865.1
(22) Anmeldetag: 09.12.2011
(51) Int. Cl.: H01L 25/16, H01L 33/48, H01L 33/62, H01L 33/64

(54) **Leuchtmodul für eine Beleuchtungseinrichtung eines Kraftfahrzeugs mit auf einem Silizium-Substrat angeordneten Halbleiterlichtquellen**

(30) Priorität: 23.12.2010 DE 202010016958 U
(71) Anmelder: Automotive Lighting Reutlingen GmbH, 72762 Reutlingen (DE)
(72) Erfinder: Gottheil, Martin, 72127 Kusterdingen (DE); Hiegler, Michael, 72760 Reutlingen (DE)
(74) Vertreter: Dreiss

(57) **Zusammenfassung**

Vorgestellt wird ein Leuchtmodul (12) für eine Beleuchtungseinrichtung (10) eines Kraftfahrzeugs, mit einer Anordnung von mehreren Halbleiterlichtquellen-Chips (14,16,18,20), die auf einer ersten Seite (22) eines Silizium-Substrates (24) angeordnet sind, sowie mit zur Steuerung der Halbleiterlichtquellen dienenden elektronischen Bauelementen, die monolithisch in das Silizium-Substrat (24) integriert sind. Das Leuchtmodul zeichnet sich dadurch aus, dass zumindest ein elektrischer Kontakt des Halbleitermaterials des Halbleiterlichtquellen-Chips (14,16,18,20) über eine zwischen dem Halbleiterlichtquellen-Chip (14,16,18,20) und dem Silizium-Substrat (24) liegende Lötstelle (62) erfolgt, die von einer der ersten Seite (22) gegenüberliegenden zweiten Seite (30) des Silizium-Substrates (24) her durch einen Laserstrahl aufgeschmolzen wurde.

## Beschreibung

Die vorliegende Erfindung betrifft ein Leuchtmodul für eine Beleuchtungseinrichtung eines Kraftfahrzeugs, mit einer Anordnung von mehreren Halbleiterlichtquellen-Chips, die auf einer ersten Seite eines Silizium-Substrates angeordnet sind, sowie mit zur Steuerung der Halbleiterlichtquellen dienenden elektronischen Bauelementen, die monolithisch in das Silizium-Substrat integriert sind.

Ein solches Leuchtmodul ist aus der DE 10 2006 040 641 A1 bekannt. Bei dem bekannten Leuchtmodul sind matrixartig angeordnete Halbleiterlichtquellen-Chips in Pyramidenstumpf-förmigen Kavitäten auf der ersten Seite des Silizium-Substrates angeordnet und über eine Metallisierung und eine Siliziumdioxid-Schicht mit dem Silizium-Substrat verbunden. Die Siliziumdioxid-Schicht wirkt als elektrisch isolierende Schicht zwischen dem Silizium-Substrat und dem Leuchtdioden-Chip. Sie stellt einen thermischen Kontakt zwischen dem Leuchtdioden-Chip und dem Silizium-Substrat her. Die zwischen der Siliziumdioxidschicht und dem Leuchtdioden-Chip liegende Metallisierung dient als elektrischer und thermischer Kontakt für den Leuchtdioden-Chip. Der Leuchtdioden-Chip wird dabei mittels einer Flip-Chip-Technik auf die Metallisierung aufgebracht. Das bedeutet, dass der Leuchtdioden-Chip mit seiner aktiven Kontaktierungsseite zum Silizium-Substrat hin montiert wird. Die elektrischen Verbindungen werden durch Verlöten des Leuchtdioden-Chips mit der Metallisierung hergestellt. Bei Kraftfahrzeugbeleuchtungseinrichtungen werden zunehmend Matrix-artige Anordnungen vieler Halbleiterlichtquellen-Chips verwendet, die einzeln ein- und ausgeschaltet werden können. Die Licht emittierende Fläche der Anordnung ergibt sich durch das Muster der jeweils eingeschalteten Halbleiterlichtquellen-Chips. Diese Fläche stellt eine erste Lichtverteilung dar, die zum Beispiel durch eine Projektionsoptik als zweite Lichtverteilung in das Vorfeld der Beleuchtungseinrichtung projiziert wird. Die Form der zweiten Lichtverteilung lässt sich durch Variation des Musters der eingeschalteten Halbleiterlichtquellen-Chips variieren. Damit lassen sich bei Scheinwerfern verschiedene Lichtverteilungen mit und ohne Hell-Dunkel-Grenze sowie mit verschiedenen Lagen der Hell-Dunkel-Grenzen erzeugen, wobei die Hell-Dunkel-Grenze sich jeweils als Bild der Grenzlinie zwischen eingeschalteten und nicht eingeschalteten Halbleiterlichtquellen-Chips ergibt. Die Erfindung ist nicht auf Scheinwerfer beschränkt und kann auch bei Signalleuchten wie Tagfahrleuchten, Bremsleuchten, etc. angewendet werden.

Um ein möglichst großes Auflösungsvermögen heller und dunkler Bereiche in der zweiten Lichtverteilung zu erzielen, ist eine hohe Packungsdichte von Halbleiterlichtquellen-Chips bei gleichzeitig möglichst kleinen Abmessungen der einzelnen Halbleiterlichtquellen-Chips auf dem Silizium-Substrat hilfreich.

Bei einer hohen Packungsdichte kleiner Halbleiterlichtquellen-Chips ergibt sich beim eingangs genannten Stand der Technik das Problem, dass beim Verlöten einzelner Chips die Lötstellen bereits verlöteter Chips in der Nachbarschaft der aktuellen Lötstelle unzulässig stark erwärmt werden, was im späteren Betrieb zu Ausfällen und Fehlfunktionen führen kann.

Vor diesem Hintergrund besteht die Aufgabe der Erfindung in der Angabe eines Leuchtmoduls, das diese Nachteile nicht aufweist. Diese Aufgabe wird mit den Merkmalen des Anspruchs 1 gelöst. Von dem eingangs genannten Stand der Technik unterscheidet sich das erfindungsgemäße Leuchtmodul dadurch, dass zumindest ein elektrischer Kontakt des Halbleitermaterials des Halbleiterlichtquellen-Chips über eine zwischen dem Halbleiterlichtquellen-Chip und dem Silizium-Substrat liegende Lötstelle erfolgt, die von einer der ersten Seite gegenüberliegenden zweiten Seite her durch einen Laserstrahl aufgeschmolzen wurde.

Das Aufschmelzen des auf der ersten Seite des Substrates liegenden Lotes durch einen von der zweiten Seite her durch das Substrat hindurch auf das Lot gerichteten Laserstrahl ist möglich, weil Silizium für Strahlung mit Wellenlängen im Bereich größer als 1100 nm quasi transparent ist. Die mit einem Laserstrahl möglich starke Fokussierung des Energieeintrags führt zu lokal genau positionierbaren und lokal eng begrenzbaren Lötstellen, die sequenziell erzeugbar sind, ohne dass beim Aufschmelzen einer Lötstelle die Lötstellenqualität benachbarter Lötstellen beeinträchtigt wird.

In Zukunft werden Halbleiterlichtquellen-Scheinwerfer als Frontscheinwerfer von Kraftfahrzeugen verwendet werden, die viele einzelne Halbleiterlichtquellen aufweisen und deren Lichtverteilung durch eine individuelle Steuerung der mittleren Helligkeiten der einzelnen Halbleiterlichtquellen beeinflussbar ist. Um zum Beispiel mit einer Matrixanordnung einer Vielzahl solcher Halbleiterlichtquellen-Chips eine Lichtverteilung zu erzeugen, in der die Lichtaustrittsflächen der einzelnen Halbleiterlichtquellen-Chips nicht mehr als einzelne Lichtaustrittsflächen wahrnehmbar sind, ist es hilfreich, die Halbleiterlichtquellen-Chips in einer hohen Packungsdichte auf einem Trägerelement anzuordnen.

Durch den damit einhergehenden geringen Abstand der einzelnen Halbleiterlichtquellen-Chips voneinander ergeben sich neue Herausforderungen an die Zuführung der elektrischen Energie an die einzelnen Halbleiterlichtquellen-Chips und an die Abfuhr der Wärme, die beim Betrieb der Halbleiterlichtquellen-Chips in diesen Chips frei wird. Aus steilen Flanken, mit denen einzelne Halbleiterlichtquellen-Chips der Anordnung eingeschaltet und ausgeschaltet werden, können sich darüber hinaus Probleme mit der elektromagnetischen Verträglichkeit solcher Scheinwerfer in Kraftfahrzeugumgebungen ergeben, die durch eine verbesserte Abschirmung zu kompensieren sind.

Die Verwendung des Silizium-Substrates erlaubt eine Lösung dieser Probleme. Das Silizium-Substrat kann mit gängigen Prozessen wie Lithographieschritten, Dotierschritten, Ätzschritten und Metallisierungsschritten bearbeitet werden. So kann eine gewünschte Leiterbahnstrukturierung in bzw. auf das Silizium des Silizium-Substrats gebracht werden. Auch können Bauteile auf dem Silizium-Substrat erzeugt werden, die zur Schaltung der Halbleiterlichtquellen-Chips dienen.

Die Halbleiterlichtquellen-Chips oder auch andere Bauteile können dann zum Beispiel durch Kleben, Löten, Bonden oder auch durch Sinterprozesse aufgebracht werden. Je nachdem, welche Bauteile verwendet werden, können auch Wirebonds zur Kontaktierung verwendet werden, die das Bauteil mit dem Silizium oder einer Metallisierung auf dem Silizium verbinden.

Aufgrund der hohen Wärmeleitfähigkeit des Siliziums wird entstehende Verlustwärme schnell weitergeleitet und kann mit oder ohne Wärmeleitsubstanzen an einen Kühlkörper weitergegeben werden. Zudem ergibt sich durch die elektrisch leitende Eigenschaft des Siliziums, die lokal durch Dotierungen beeinflusst werden kann, der Vorteil einer Abschirmung elektromagnetischer Wellen.

Als zusätzliche Vorteile der Erfindung ergeben sich demnach eine verbesserte elektromagnetische Verträglichkeit und ein Potenzial für ein verbessertes Thermomanagement.

Weitere Vorteile ergeben sich aus den abhängigen Ansprüchen, der Beschreibung und den beigefügten Figuren.

Es versteht sich, dass die vorstehend genannten und die nachstehend noch zu erläuternden Merkmale nicht nur in der jeweils angegeben Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Dabei zeigen, jeweils in schematischer Form:
- Figur 1: das technische Umfeld der Erfindung in Form einer Beleuchtungseinrichtung eines Kraftfahrzeugs in einer Seitenansicht;
- Figur 2: eine perspektivische Darstellung eines Teilbereiches eines Silizium-Substrates, das als Trägerelement für eine Matrix von Halbleiterlichtquellen-Chips dient;
- Figur 3: einen Querschnitt durch eine bevorzugte Ausgestaltung des Silizium-Substrates mit einem Halbleiterlichtquellen-Chip, und
- Figur 4: ein weiteres Ausführungsbeispiel eines Silizium-Substrates mit einem Halbleiterlichtquellen-Chip.

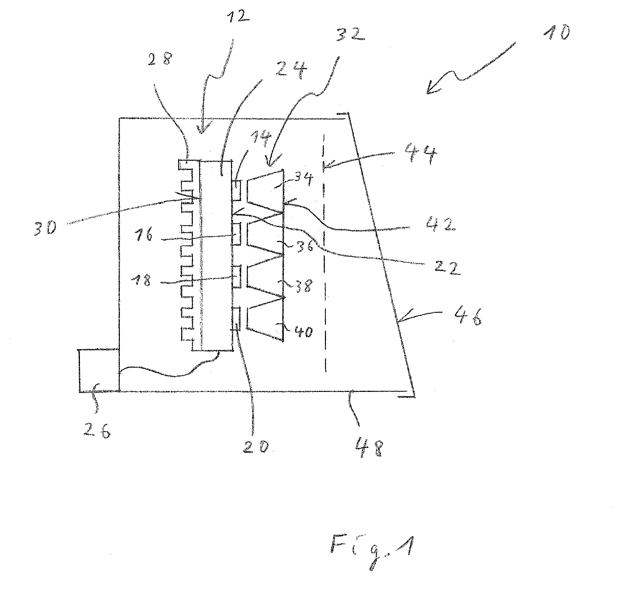

Im Einzelnen zeigt die Fig. 1 eine Beleuchtungseinrichtung 10 eines Kraftfahrzeuges. In der dargestellten Ausgestaltung ist die Beleuchtungseinrichtung 10 ein Scheinwerfer. Die Beleuchtungseinrichtung 10 weist ein Leuchtmodul 12 auf. Das Leuchtmodul 12 weist eine Anordnung von mehreren Halbleiterlichtquellen-Chips 14, 16, 18, 20 auf, die auf einer ersten Seite 22 eines Silizium-Substrates 24 angeordnet sind. In das Silizium-Substrat 24 sind zur Steuerung der Halbleiterlichtquellen-Chips 14, 16, 18, 20 dienende elektronische Bauelemente monolithisch integriert. Die Halbleiterlichtquellen-Chips 14, 16, 18, 20 werden von einem Lichtsteuergerät 26 gesteuert, wobei die Steuerung zum Beispiel in Abhängigkeit vom Signal eines Fahrerwunschgebers oder eines anderen Steuergeräts des Fahrzeugs erfolgt. Die beim Betrieb der Halbleiterlichtquellen-Chips 14, 16, 18, 20 in diesen Chips auftretende elektrische Verlustwärme wird durch das gut Wärme leitende Silizium-Substrat 24 aufgenommen und über einen oder mehrere Kühlkörper 28 an die Umgebungsluft abgegeben. Der oder die Kühlkörper 28 sind an einer der ersten Seite 22 des Silizium-Substrates 24 gegenüberliegenden zweiten Seite 30 des Silizium-Substrates 24 angeordnet.

Das von den Halbleiterlichtquellen-Chips 14, 16, 18, 20 ausgehende Licht wird von einem Optikarray 32 aus Primäroptiken 34, 36, 38, 40 gebündelt. Die Primäroptiken 34, 36, 38, 40 sind bevorzugt als mit interner Totalreflexion Licht bündelnde Lichtleiter realisiert, die eine zusammenhängende Lichtaustrittsfläche 42 bilden. Jedem Halbleiterlichtquellen-Chip 14, 16, 18, 20 ist bevorzugt genau eine solche Lichtleiter-Primäroptik 34, 36, 38, 40 zugeordnet. Benachbarte Halbleiterlichtquellen-Chips, die gemeinsam eingeschaltet sind, ergeben eine zusammenhängende Lichtverteilung auf der genannten Lichtaustrittsfläche 42, in der Abstände, die die Halbleiterlichtquellen-Chips auf der ersten Seite 22 des Silizium-Substrates 24 trennen, im Idealfall nicht erkennbar sind. Diese erste Lichtverteilung wird in der dargestellten Ausgestaltung von einer Sekundäroptik 44, die zum Beispiel als Sammellinse realisiert ist, als zweite Lichtverteilung durch eine transparente Abdeckscheibe 46 in das Vorfeld der Beleuchtungseinrichtung 12 projiziert. Dabei deckt die Abdeckscheibe 46 eine Lichtaustrittsöffnung in einem Gehäuse 48 der Beleuchtungseinrichtung 12 ab.

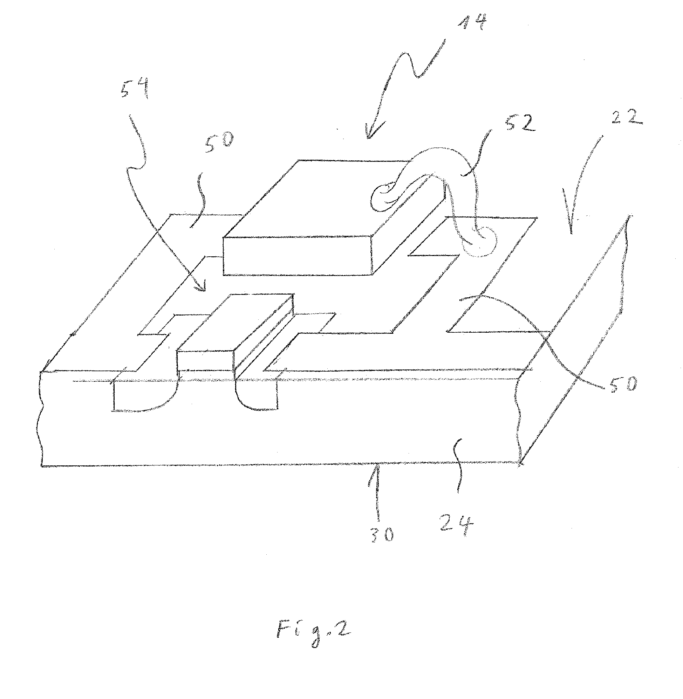

Die Figur 2 zeigt eine perspektivische Darstellung eines Teilbereiches eines Silizium-Substrates 24, das als Trägerelement für eine Matrix von Halbleiterlichtquellen-Chips dient. Stellvertretend für die Matrix zeigt die Figur einen einzelnen Halbleiterlichtquellen-Chip 14, der auf einer ersten Seite 22 des Silizium-Substrates 24 auf dem Silizium-Substrat 24 zum Beispiel geklebt oder eutektisch gebondet aufliegt. Die elektrische Kontaktierung erfolgt in der dargestellten Ausgestaltung durch eine auf der ersten Seite 22 des Silizium-Substrates 24 liegende Metallisierung 50.

Dabei erfolgt zumindest ein elektrischer Kontakt des Halbleitermaterials des Halbleiterlichtquellen-Chips 14 über eine zwischen dem Halbleiterlichtquellen-Chip 14 und dem Silizium-Substrat 24 liegende Lötstelle (in der Fig. 2 verdeckt), die von einer der ersten Seite 22 gegenüberliegenden zweiten Seite 30 des Silizium-Substrates her durch einen Laserstrahl aufgeschmolzen wurde. Dieser elektrische Kontakt liegt damit auf einer Unterseite des Halbleiterlichtquellen-Chips 14.

In der dargestellten Ausgestaltung erfolgt ein zweiter elektrischer Kontakt des Halbleitermaterials des Halbleiterlichtquellen-Chips 14 über einen zwischen dem Halbleiterlichtquellen-Chip 14 und der Metallisierung liegenden metallischen Bond-Draht 52, der eine leitende Verbindung der Metallisierung 50 zu einer der Unterseite des Halbleiterlichtquellen-Chips 14 gegenüberliegenden Oberseite des Halbleiterlichtquellen-Chips erzeugt. Alternativ oder ergänzend erfolgt auch eine zweiter elektrischer Kontakt über eine Lötstelle, mit der ein Teil einer der ersten Seite 22 des Silizium-Substrats 24 zugewandten Unterseite des Halbleiterlichtquellen-Chips 14 an die Metallisierung 50 angeschlossen ist.

Ein besonderer Vorteil der Verwendung von Silizium als Substratmaterial für das Trägerelement der Anordnung der der Halbleiterlichtquellen-Chips 14, 16, 18, 20 ergibt sich in diesem Zusammenhang dadurch, dass Silizium im Wellenlängenbereich der sogenannten nahen Infrarotstrahlung das heißt bei Wellenlängen, die größer als 1100 nm sind, nur wenig Strahlungsenergie absorbiert. Das Silizium ist für diese Infrarotstrahlung daher transparent. Dies erlaubt eine Energiezufuhr zur Lötstelle von einer Rückseite 30 des Silizium-Substrates 24 her die durch das Silizium-Substrat 24 hindurch erfolgt. Die Energiezufuhr erfolgt durch auf die Lötstelle fokussierte Laserstrahlung mit einer Wellenlänge in dem genannten Bereich der nahen Infrarotstrahlung, zum Beispiel mit einer Wellenlänge von 1550 nm. Zum Schmelzen eines AuSn-Lotes (Gold-Zinn) ist zum Beispiel eine Aufheizung des Lotes auf eine Temperatur von 280°C erforderlich. Mit Hilfe eines Lasers kann diese Temperatur lokal sehr eng begrenzt erzeugt werden.

Das Herstellen einer einzelnen Lötstelle führt daher nicht zu einem erneuten Aufschmelzen gegebenenfalls vorhandener weiterer Lötstellen in der Nachbarschaft der herzustellenden einzelnen Lötstelle. Dadurch ergibt sich die Möglichkeit, die Halbleiterlichtquellen-Chips 14, 16, 18, 20 mit geringem Abstand voneinander und daher mit hoher Packungsdichte auf dem Silizium-Substrat 22 anzuordnen. Das ist insbesondere für Halbleiterlichtquellen-Matrixscheinwerfer ein Vorteil, weil geringe Abstände zwischen den leuchtenden Flächen einer solchen Halbleiterlichtquellen-Anordnung dazu beitragen, unerwünschte dunkle Linie oder Gitterstrukturen in der Lichtverteilung zu vermeiden, die von einem solchen Scheinwerfer erzeugt wird.

Ein weiterer Vorteil besteht darin, dass kleinere Halbleiterlichtquellen-Chips als üblich verwendet werden können. Üblicherweise werden in dem hier genannten technischen Umfeld der Beleuchtungseinrichtungen von Kraftfahrzeugen Halbleiterlichtquellen-Chips mit einer Kantenlänge von 1 mm verwendet. Die Erfindung erlaubt auch eine Verwendung von Halbleiterlichtquellen mit einer Kantenlänge von z.B. 0,75 mm, was im Ergebnis zu einer besseren Auflösung von Hell-Dunkel-Grenzen in der resultierenden Lichtverteilung führt.

Die nicht zum Anschluss elektrischer und/oder thermischer Kontakte dienenden Bereiche der Rückseite eines Halbleiterlichtquellen-Chips 14, 16, 18, 20, mit der dieser auf der ersten Seite 22 des Silizium-Substrates 24 aufliegt, sind bevorzugt verspiegelt, um möglichst viel von dem innerhalb des Halbleiterlichtquellen-Chips erzeugten Licht über dessen Vorderseite austreten zu lassen.

Mit Blick auf ihren Einfluss den auf den vom Halbleiterlichtquellen-Chip emittierten Lichtstrom spielt es keine große Rolle, ob der Halbleiterlichtquellen-Chip durch Bond-Drähte von seiner Vorderseite her oder durch auf seiner Rückseite liegende Lötpunkte an die Metallisierung angeschlossen ist. Die Lötpunkte auf der Rückseite verkleinern die verspiegelte Fläche, während die auf der Vorderseite liegenden Lötpunkte der Bond-Drähte die Lichtaustrittsfläche verkleinern. Die auf der Rückseite liegenden Lötstellen ermöglichen jedoch eine höhere Packungsdichte.

In der Ausgestaltung, die in der Figur 2 dargestellt ist, liegt das Halbleitermaterial des Halbleiterlichtquellen-Chips 14 parallel zum Strompfad eines Feldeffekttransistors 54, der monolithisch in das Silizium-Substrat 24 integriert ist. Die Widerstandsverhältnisse in dem über den Transistor 54 führenden Strompfad und in dem über den Halbleiterlichtquellen-Chip 14 führenden Strompfad sind dabei so, dass der Halbleiterlichtquellen-Chip 14 durch Einschalten des Transistors 54 ausgeschaltet und durch Ausschalten des Transistors 54 eingeschaltet werden kann. Alternativ zu einer solchen Parallelschaltung des Transistors 54 zum Halbleiterlichtquellen-Chip 14 kann der zur Steuerung der Lichtleistung dienende Transistor 54 auch mit dem Halbleiterlichtquellen-Chip 14 in Reihe geschaltet sein. Die Lichtleistung wird dann in einer bevorzugten Ausgestaltung durch eine Pulsweiten-modulierte Ansteuerung des Transistors 54 gesteuert, mit der der Halbleiterlichtquellen-Chip 14 so schnell an- und ausgeschaltet wird, dass der menschliche Sehsinn nur eine vom Tastverhältnis abhängige mittlere Helligkeit wahrnimmt. Dies ist zum Beispiel bei einer Ansteuerung mit einer Frequenz von mehr als 200 Hz der Fall.

Weitere Ausgestaltungen sehen vor, dass das Silizium-Substrat 24 alternativ oder ergänzend zu Steuertransistoren 54 monolithisch integrierte Bauelemente, wie eine Transient-Voltage-Suppressor-Diode (TVS-Diode) oder eine ein solches Bauelement aufweisende Schaltung zum Schutz vor Electrostatic-Discharge-Ereignissen (ESD) aufweist. Die monolithische Integration solcher Bauelemente und/oder Schaltungen ist aus der Fertigung integrierter Schaltungen bekannt.

Weitere Ausgestaltungen sehen eine Dotierung des Silizium-Substrates 24 vor, mit der eine Abschirmung der in das Substrat 24 integrierten Bauelemente und Leiterbahnen in Bezug auf eine Emission und/oder Einkopplung elektromagnetischer Strahlung verbessert wird. Eine solche Abschirmwirkung ergibt sich aber auch bereits ohne zusätzliche Dotierungen durch die Leitfähigkeit des Silizium-Substrates. Eine Abschirmung in Bezug auf eine Emission elektromagnetischer Wellen ist unter Umständen deshalb erforderlich, um die elektromagnetische Verträglichkeit in einer Kraftfahrzeugumgebung sicherzustellen. Die Abstrahlung elektromagnetischer Wellen kann zum Beispiel dadurch angeregt werden, dass die einzelnen Halbleiterlichtquellen-Chips 14, 16, 18, 20 eines solchen Matrix-Scheinwerfers mit Pulsweiten-modulierten Signalen angesteuert werden, um mittlere Helligkeiten der Halbleiterlichtquellen-Chips 14, 16, 18, 20 auf vorgegebene Sollwerte einzustellen. Bei mit Frequenzen von über 200 Hz erfolgenden Ein- und Ausschaltvorgängen ergeben sich mit dieser Frequenz steile Schaltflanken, deren hochfrequente Fourier-Komponenten die unerwünschte Abstrahlung elektromagnetischer Wellen zur Folge haben können.

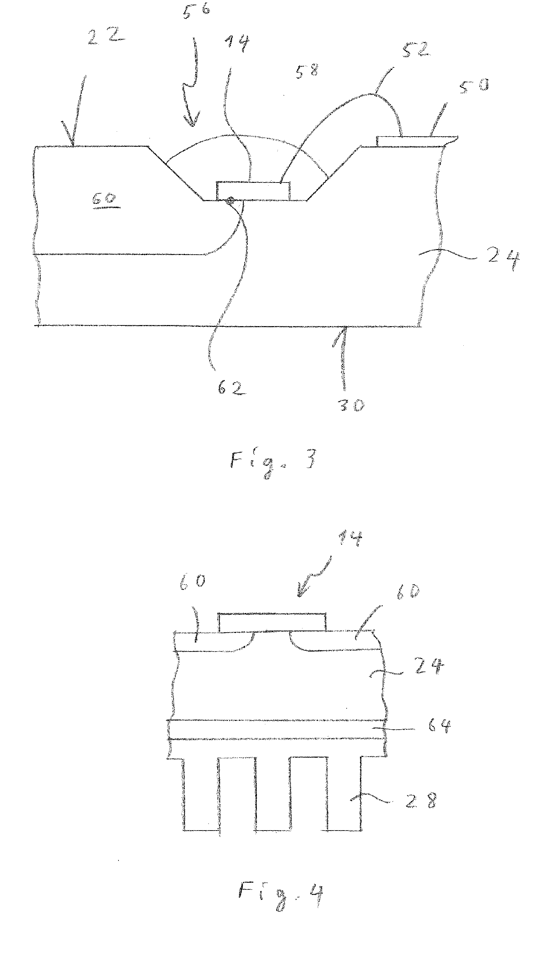

Die Figur 3 zeigt einen Querschnitt durch eine bevorzugte Ausgestaltung des Silizium-Substrates 24 mit einem Halbleiterlichtquellen-Chip 14. In dieser Ausgestaltung weist das Silizium-Substrat 24 auf seiner eine erste Seite 22 bildenden Vorderseite eine Vertiefung 56 auf, die dazu eingerichtet ist, einen Halbleiterlichtquellen-Chip 14 aufzunehmen. Der Boden und die Seitenwände der Vertiefung 56 sind bevorzugt verspiegelt, um das von dem Halbleiterlichtquellen-Chip 14 ausgehende Licht in eine Vorzugsrichtung zu bündeln. Die Vertiefung dient damit als Reflektor. Aber auch für den Fall, dass keine gesonderte Verspiegelung der reflektierenden Grenzflächen vorgesehen ist, sorgt der große Brechzahlunterschied zwischen dem Silizium-Substrat (Brechzahl n = 3,5) und der Luft (Brechzahl n = 1) oder einer den LD-Chip 14 umgebenden transparenten Vergussmasse 58 (Brechzahl n = z.B. 1,5) für einen vorteilhaft hohen Reflexionsgrad des an der Grenzfläche der Vertiefung 56 zum Silizium-Substrat 24 reflektierten Lichtes.

Die Verspiegelung erfolgt zum Beispiel durch eine metallische Beschichtung. Die Figur 3 zeigt darüber hinaus eine Kontaktierungsalternative, bei der ein Kontakt des Halbleiterlichtquellen-Chips 14, hier der in der Figur 3 linke und untere Kontakt des Halbleiterlichtquellen-Chips 14, an einen dotierten Bereich 60 des Silizium-Substrats 24 angeschlossen ist. Der elektrische Kontakt wird dabei bevorzugt durch eine Lötverbindung 62 hergestellt, die bevorzugt durch Aufschmelzen eines Lotes durch einen Laserstrahl von der Rückseite 30 des Silizium-Substrates 24 her erzeugt worden ist.

Die Figur 4 zeigt ein weiteres Ausführungsbeispiel eines Silizium-Substrates 24 mit einem Halbleiterlichtquellen-Chip 14, der auf einer eine erste Seite 22 bildenden Vorderseite des Silizium-Substrates 24 angeordnet ist, und mit einen Kühlkörper 28, der auf einer Rückseite 30 des Silizium-Substrates 24 angeordnet ist und der in einer Ausgestaltung mit einem thermisch leitfähigen Kleber 64 mit dem Silizium-Substrat 24 verbunden ist. Die im Halbleiterlichtquellen-Chip 14 bei dessen Betrieb freigesetzte Wärme wird durch das gut wärmeleitende Silizium-Substrat 24 aufgenommen und an den Kühlkörper 28 weitergeleitet, der die Wärme schließlich an die Umgebung abgibt.

Aufgrund der hohen Wärmeleitfähigkeit des Silizium-Substrates lassen sich hohe Packungsdichten von Halbleiterlichtquellen-Chips 14, 16, 18, 20 auf der die erste Seite 22 bildenden Vorderseite des als Trägerelement dienenden Silizium-Substrates 24 realisieren, ohne dass in dem Trägerelement aufwändige Kühlmaßnahmen vorgesehen werden müssen, wie es zum Beispiel bei herkömmlichen Leiterplatten in Form von Metallkernplatinen erforderlich ist. Der Chip 14 wird in der dargestellten Ausgestaltung von unten über dotierte Bereiche 60 des Silizium-Substrates 24 kontaktiert.

Dabei werden die elektrischen Kontakte auch hier bevorzugt durch Lötverbindungen hergestellt, die durch Aufschmelzen eines Lotes durch einen Laserstrahl von der Rückseite 30 des Silizium-Substrates 24 her erzeugt worden sind. Solche Lötverbindungen sind durch ihre Lage zwischen dem Chip und dem Substrat und durch ihre geringe Ausdehnung von anders hergestellten Lötverbindungen unterscheidbar und stellen daher ein strukturelles Vorrichtungsmerkmal dar.

## Patentansprüche

1. Leuchtmodul (12) für eine Beleuchtungseinrichtung (10) eines Kraftfahrzeugs, mit einer Anordnung von mehreren Halbleiterlichtquellen-Chips (14, 16, 18, 20), die auf einer ersten Seite (22) eines Silizium-Substrates (24) angeordnet sind, sowie mit zur Steuerung der Halbleiterlichtquellen (14, 16, 18. 20) dienenden elektronischen Bauelementen, die monolithisch in das Silizium-Substrat (24) integriert sind, **dadurch gekennzeichnet, dass** zumindest ein elektrischer Kontakt des Halbleitermaterials des Halbleiterlichtquellen-Chips (14, 16, 18, 20) über eine zwischen dem Halbleiterlichtquellen-Chip (14, 16, 18, 20) und dem Silizium-Substrat (24) liegende Lötstelle (62) erfolgt, die von einer der ersten Seite (22) gegenüberliegenden zweiten Seite (30) des Silizium-Substrates (24) her durch einen Laserstrahl aufgeschmolzen wurde.

2. Leuchtmodul (12) nach Anspruch 1, **dadurch gekennzeichnet, dass** die elektrische Kontaktierung durch eine auf der ersten Seite (22) des Silizium-Substrates (24) liegende Metallisierung (50) erfolgt, wobei ein zweiter elektrischer Kontakt des Halbleitermaterials des Halbleiterlichtquellen-Chips 14 über einen zwischen dem Halbleiterlichtquellen-Chip 14 und der Metallisierung liegenden metallischen Bond-Draht 52 erfolgt, der eine leitende Verbindung der Metallisierung 50 zu einer der Unterseite des Halbleiterlichtquellen-Chips 14 gegenüberliegenden Oberseite des Halbleiterlichtquellen-Chips erzeugt.

3. Leuchtmodul (12) nach einem der vorhergehenden Ansprüche, **dadurch gekennzeichnet, dass** ein zweiter elektrischer Kontakt über eine Lötstelle erfolgt, mit der ein Teil einer der ersten Seite (22) des Silizium-Substrats (24) zugewandten Unterseite des Halbleiterlichtquellen-Chips (14) an die Metallisierung (50) angeschlossen ist.

4. Leuchtmodul (12) nach einem der vorhergehenden Ansprüche, **dadurch gekennzeichnet, dass** ein Kontakt des Halbleiterlichtquellen-Chips (14) an einen dotierten Bereich (60) des Silizium-Substrats (24) angeschlossen ist, wobei der sich der elektrische Kontakt durch eine Lötverbindung (62) ergibt.

5. Leuchtmodul (12) nach einem der vorhergehenden Ansprüche, **dadurch gekennzeichnet**, nicht zum Anschluss elektrischer und/oder thermischer Kontakte dienende Bereiche der Rückseite eines Halbleiterlichtquellen-Chips (14, 16, 18, 20) mit der dieser auf der ersten Seite (22) des Silizium-Substrates (24) aufliegt, verspiegelt sind.

6. Leuchtmodul (12) nach einem der vorhergehenden Ansprüche, **dadurch gekennzeichnet, dass** das Halbleitermaterial des Halbleiterlichtquellen-Chips (14) parallel oder in Reihe zum Strompfad eines Transistors (54) liegt, der monolithisch in das Silizium-Substrat (24) integriert ist.

7. Leuchtmodul (12) nach einem der vorhergehenden Ansprüche, **dadurch gekennzeichnet, dass** das Silizium-Substrat (24) alternativ oder ergänzend zu Steuertransistoren (54) monolithisch integrierte Bauelemente, wie eine Transient-Voltage-Suppressor-Diode (TVS-Diode) oder eine ein solches Bauelement aufweisende Schaltung zum Schutz vor Electrostatic-Discharge-Ereignissen (ESD) aufweist.

8. Leuchtmodul (12) nach einem der vorhergehenden Ansprüche, **dadurch gekennzeichnet, dass** das Silizium-Substrat (24) eine Dotierung aufweist, mit der eine Abschirmung der in das Substrat (24) integrierten Bauelemente und Leiterbahnen in Bezug auf eine Emission und/oder Einkopplung elektromagnetischer Strahlung verbessert wird.

9. Leuchtmodul (12) nach einem der vorhergehenden Ansprüche, **dadurch gekennzeichnet, dass** das Silizium-Substrat (24) auf seiner eine erste Seite (22) bildenden Vorderseite eine Vertiefung (56) aufweist, die dazu eingerichtet ist, einen Halbleiterlichtquellen-Chip (14) aufzunehmen.

10. Leuchtmodul (12) nach einem der vorhergehenden Ansprüche, **dadurch gekennzeichnet, dass** der Boden und die Seitenwände der Vertiefung (56) verspiegelt sind.

11. Leuchtmodul (12) nach einem der vorhergehenden Ansprüche, **gekennzeichnet durch** wenigstens einen Kühlkörper (28), der an einer einer ersten Seite (22) des Silizium-Substrates (24) gegenüberliegenden zweiten Seite (30) des Silizium-Substrates (24) angeordnet ist.

12. Leuchtmodul (12) nach einem der vorhergehenden Ansprüche, **gekennzeichnet durch** ein Licht der Halbleiterlichtquellen-Chips (14, 16, 18, 20) bündelndes Optikarray (32) aus Primäroptiken (34, 36, 38, 40).

13. Leuchtmodul (12) nach Anspruch 14, **dadurch gekennzeichnet, dass** die Primäroptiken (34, 36, 38, 40) als mit interner Totalreflexion Licht bündelnde Lichtleiter realisiert sind, die eine zusammenhängende Lichtaustrittsfläche (42) bilden.

14. Leuchtmodul (12) nach Anspruch 15, **dadurch gekennzeichnet, dass** jedem Halbleiterlichtquellen-Chip (14, 16, 18, 20) genau eine Lichtleiter-Primäroptik (34, 36, 38, 40) zugeordnet ist.

15. Leuchtmodul (12) nach Anspruch 13 oder 14, **gekennzeichnet durch** eine Sekundäroptik (44), die eine erste Lichtverteilung, die sich auf der zusammenhängenden Lichtaustrittsfläche (42) bildet, als zweite Lichtverteilung **durch** eine transparente Abdeckscheibe (46) der Beleuchtungseinrichtung (12) hindurch in das Vorfeld der Beleuchtungseinrichtung (12) projiziert.
